(19) Europäisches Patentamt

European Patent Office

Office européen des brevets

(11) Veröffentlichungsnummer: **0 316 607 B1**

(12) **EUROPÄISCHE PATENTSCHRIFT**

(45) Veröffentlichungstag der Patentschrift: **30.12.92**

(21) Anmeldenummer: **88117481.7**

(22) Anmeldetag: **20.10.88**

(51) Int. Cl.⁵: **H03L 7/08**, H03K 3/03

(54) **Monolithisch integrierbarer Phasenschieber-VCO.**

(30) Priorität: **19.11.87 DE 3739210**

(43) Veröffentlichungstag der Anmeldung:
**24.05.89 Patentblatt 89/21**

(45) Bekanntmachung des Hinweises auf die
Patenterteilung:
**30.12.92 Patentblatt 92/53**

(84) Benannte Vertragsstaaten:
**DE FR GB IT NL**

(56) Entgegenhaltungen:
**EP-A- 0 220 454**
**GB-A- 2 053 608**
**US-A- 3 452 289**

**IEEE JOURNAL OF SOLID STATE CIRCUITS,
Band SC-5, Februar 1970, Seiten 45-48, New
York, US; C.R. RYAN: "Applications of a four-
quadrant multiplier"**

**IBM TECHNICAL DISCLOSURE BULLETIN,
Band 16, Nr. 11, April 1974, Seiten 3498-3500,
IEEE, New York, US; P.T. MARINO: "Variable
delay pulse circuits"**

(73) Patentinhaber: **SIEMENS AKTIENGESELL-
SCHAFT
Wittelsbacherplatz 2
W-8000 München 2(DE)**

(72) Erfinder: **Wilhelm, Wilhelm, Dr.
Geigenbergerstrasse 23
W-8000 München 71(DE)**
Erfinder: **Birth, Winfrid, Dipl.-Ing.
Plankenhofstrasse 9a
W-8000 München 81(DE)**

## Beschreibung

Die Erfindung betrifft einen monolithisch integrierbaren Phasenschieber-Oszillator mit spannungsabhängiger Frequenz nach dem Oberbegriff des Patentanspruches 1.

Aus dem Buch von J.L. Stewart, "Theorie und Entwurf elektrischer Netzwerke", Kapitel 13, insbesondere den Seiten 387 und 388 sind Phasenschieber-Oszillatoren bekannt, bei denen das Ausgangssignal einer Addieranordnung mit negativem Vorzeichen über zwei parallel angeordnete, sich in ihrer Laufzeit bzw. ihrem Frequenzverhalten unterscheidende Netzwerke an die Eingänge besagter Addieranordnung rückgekoppelt ist, wobei durch Variation der Gewichtsfaktoren der die unterschiedlichen Netzwerke durchlaufenden Signale die Frequenz solcher Oszillatoren verändert werden kann.

Eine monolithisch integrierbare Addieranordnung, bei der durch eine Steuerspannung die Gewichtsfaktoren der beiden Eingangssignale insbesondere entgegengesetzt verändert werden können, wird in der US-Patentschrift 3 452 289 vom 24.06.1969 beschrieben. Hierbei handelt es sich um eine Verstärkeranordnung, bestehend aus einer Konstantstromquelle, einem unteren Differenzverstärkerpaar mit einem ersten und einem zweiten Transistor, wobei die Emitteranschlüsse dieser beiden Transistoren zusammengeschaltet und mit der besagten Konstantstromquelle verbunden sind und die Basisanschlüsse dieses ersten und zweiten Transistors je einen Steuersignaleingang bilden, aus einem ersten oberen Differenzverstärkerpaar mit einem dritten und einem vierten Transistor, wobei die Emitteranschlüsse dieses dritten und vierten Transistors zusammengeschaltet und mit dem Kollektoranschluß des ersten Transistors verbunden sind, der Basisanschluß dieses dritten Transistors einen ersten nichtinvertierenden Signaleingang und der Basisanschluß des vierten Transistors einen ersten invertierenden Signaleingang bildet, aus einem zweiten oberen Differenzverstärkerpaar mit einem fünften und einem sechsten Transistor, wobei die Emitteranschlüsse dieses fünften und sechsten Transistors zusammengeschaltet und mit dem Kollektoranschluß des zweiten Transistors verbunden sind, der Basisanschluß dieses fünften Transistors einen zweiten nichtinvertierenden und der Basisanschluß des sechsten Transistors einen zweiten invertierenden Eingang bildet, wobei der Kollektoranschluß des dritten Transistors mit dem Kollektoranschluß des fünften Transistors zusammengeschaltet ist und beide einen ersten Signalausgang bilden, wobei der Kollektoranschluß des vierten Transistors mit dem Kollektoranschluß des sechsten Transistors zusammengeschaltet ist und beide einen zweiten Signalausgang bilden, wobei das Signal dieses zweiten Signalausganges invers zum Signal des ersten Signalausganges ist und die beiden Signalausgänge an einer Ausgangsschaltung angeschlossen sind.

Schaltkreise mit einstellbaren Verzögerungszeiten sind im Dokument IBM Technical Disclosure Bulletin, Band 16, Nr. 11, April 1974, Seiten 3498 bis 3500 beschrieben.

In einem Artikel von C.R. Ryan, "Applications of a four-quadrant multiplayer", der in der Zeitschrift "IEEE journal of solid-state circuits¨ vom Februar 1970 auf den Seiten 45 bis 48 veröffentlicht worden ist, wird ein Oszillator mit spannungssteuerbarer Frequenz (voltage controlled oszillator VCO) zur Erzeugung unsymmetrischer Ausgangssignale gezeigt, der dadurch realisiert wird, daß ein Ausgang der oben beschriebenen, der US-Patentschrift 3 452 289 entnommenen Schaltung an ein erstes RC-Glied angeschlossen ist und das durch dieses erste RC-Glied verzögerte Ausgangssignal dieses Ausganges über eine Widerstandsschaltung ohne weitere Verzögerung an den zweiten nichtinvertierenden Eingang und über ein zweites, das Signal verzögerndes RC-Glied an den ersten nichtinvertierenden Eingang der Schaltung geschaltet ist, daß ein Steuersignaleingang zur Variation der Oszillatorfrequenz mit einer Abstimmspannung beaufschlagt wird, die invertierenden Signaleingänge an das Bezugspotential geschaltet sind und der andere Steuersignaleingang mit einem konstanten Potential beaufschlagt wird.

Je größer in solchen Schaltungen die Zeitkonstante des ersten RC-Gliedes gewählt wird, desto niedriger ist die Frequenz des entsprechenden Oszillators. Wird auf diese Weise die Oszillatorfrequenz herabgesetzt, so ist das Verhältnis der maximalen VCO-Frequenz zur über die Steuersignaleingänge einstellbaren minimalen VCO-Frequenz bei abgesehen vom ersten RC-Glied gleicher Oszillatorschaltung für die niedrigere maximale VCO-Frequenz geringer als für die einer kleineren Zeitkonstanten des ersten RC-Gliedes entsprechenden höhere maximale VCO-Frequenz. Die maximale VCO-Frequenz wird durch maximale Gewichtung des durch das zweite RC-Glied verzögerten rückgekoppelten Signales und durch minimale Gewichtung des durch das Widerstandsnetzwerk nicht verzögerten rückgekoppelten Signales erreicht. Die minimale VCO-Frequenz erfordert eine entsprechend entgegengesetzte Verteilung der Gewichtsfaktoren. Die Widerstände und die Kapazitäten der in der in dem oben beschriebenen Artikel von C. R. Ryan gezeigten Schaltung vorgesehenen RC-Glieder und des Widerstandsnetzwerkes erfordern bei monolithischer Integration der Schaltung eine große Chip-Fläche, so daß diese Schaltung nicht sinnvoll vollständig monolithisch integrierbar ist.

Ein in dem Artikel von Ryan beschriebener Oszillator zeichnet sich durch einen kleinen nutzbaren Variationsbereich der Abstimmspannung aus und außerdem ist die Ausgangsfrequenzänderung nur in einem relativ kleinen Bereich linear von der Abstimmspannungsänderung abhängig. Trägt man in einem orthogonalen Koordinatensystem die VCO-Frequenz über der Abstimmspannung auf, so erhält man also für einen beschriebenen Oszillator gemäß dem oben erwähnten Artikel von Ryan eine Frequenz-Abstimmspannungs-Kennlinie, die innerhalb eines relativ geringen Frequenzbereichs linear ist, wobei dieser lineare Bereich außerdem eine recht hohe Steilheit aufweist.

In vielen Anwendungsfällen, insbesondere beim Einsatz in breitbandigen PLL-Schaltungen ist jedoch ein linearer Zusammenhang zwischen der Abstimmspannung und der VCO-Frequenz über einen größeren Frequenzbereich erforderlich. Außerdem ist ein möglichst flacher Verlauf der Frequenz-Abstimmspannungs-Kennlinie mit einem möglichst großen Spannungs-Variationsbereich des linearen Abschnittes der Frequenz-Abstimmspannungs-Kennlinie von Vorteil, weil dann unerwünschte Abstimmspannungsschwankungen, wie z. B. Rauschen, die VCO-Frequenz nicht zu sehr beeinflussen. Ein Abflachen dieser Kennlinie kann in oben beschriebenen Schaltungen der US-PS 3 452 289 durch Stromgegenkopplung des unteren Differenzverstärkers erreicht werden.

In dem Buch von Tietze/Schenk, "Halbleiter-Schaltungstechnik", 7. Auflage, 1985 wird auf Seite 337 in Abbildung 12.38 das Schaltbild eines Vierquadranten-Steilheitsmultiplizierers gezeigt. Hierbei handelt es sich, abgesehen von einer zusätzlichen Schaltgruppe, um eine Schaltung, wie sie oben beschrieben aus der US-PS 3 452 289 bekannt ist, wobei der oben beschriebene erste und zweite Signaleingang zu einem Signaleingang zusammengefaßt sind und wobei die besagte Stromgegenkopplung dadurch erreicht wird, daß anstelle der an die Emitteranschlüsse der beiden Transistoren des unteren Differenzverstärkertransistorpaares angeschlossenen Konstantstromquelle für jeden dieser Emitteranschlüsse eine gesonderte Konstantstromquelle vorgesehen ist und die Emitteranschlüsse nicht unmittelbar sondern über einen Koppelwiderstand miteinander verbunden sind.

Aufgabe der Erfindung ist die Bereitstellung eines monolithisch integrierbaren Oszillators mit spannungssteuerbarer Frequenz, dessen Ausgangsfrequenz über einen möglichst weiten Bereich linear von der Abstimmspannung abhängt, wobei die Breite des diesem Frequenzbereich entsprechenden Abstimmspannungsbereiches vorgegeben werden kann.

Diese Aufgabe wird erfindungsgemäß durch eine Schaltungsanordnung nach dem Patentanspruch 1 gelöst.

Besonders günstige Ausgestaltungsformen sind Gegenstand von Unteransprüchen.

Der Gegenstand der Erfindung wird nachfolgend anhand von Ausführungsbeispielen und den FIG 1 bis 3 näher erläutert.

FIG 1     zeigt eine spezielle Ausführungsform des Gegenstandes des Patentanspruches 1, die aus drei Grundschaltungen GS1, GS2, GS3 aufgebaut ist.

FIG 2     zeigt den für Breitband-PLL-Schaltungen anzustrebenden Frequenz-Abstimmspannungszusammenhang, wie er mit Hilfe von Schaltungen nach FIG 1 durch entsprechende Abstufung der drei Referenzspannung Uref1, Uref2, Uref3 und der Koppelwiderstände Rk der drei Grundschaltung GS1, GS2 und GS3 erreicht werden kann.

FIG 3     zeigt eine Ausführungsform eines erfindungsgemäßen Oszillators, die den Betrieb bei niedrigeren Frequenzen ermöglicht, ohne den relativen Stellbereich zu verkleinern und die außerdem Ausgangssignale der gleichen Frequenz verschiedener, fester Phasenlagen bereitstellt.

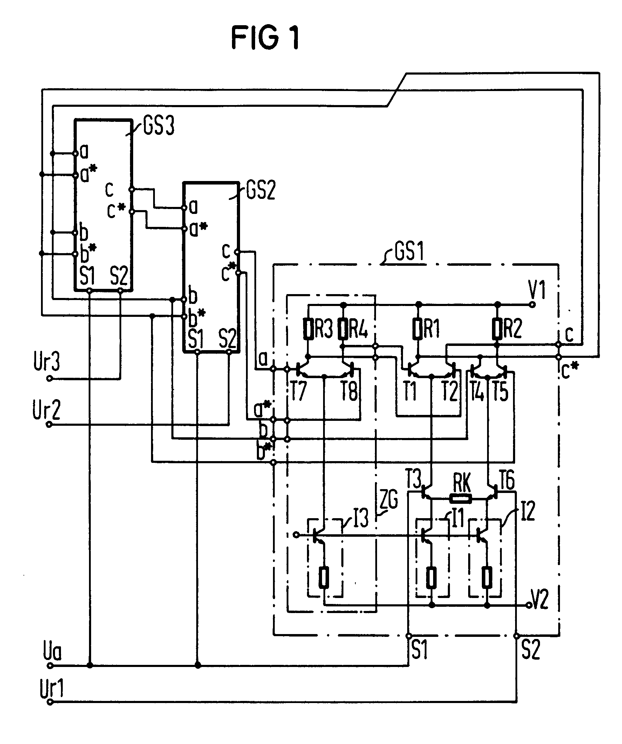

FIG 1 zeigt in einer speziellen Ausführungsform einen Phasenschieber-Oszillator mit spannungssteuerbarer Ausgangsfrequenz, bestehend aus Grundschaltungen GS1, GS2, GS3..., wobei jede Grundschaltung einen symmetrischen ersten Eingang a, a*, einen symmetrischen zweiten Eingang b, b*, einen Steuereingang S1, einen Referenzeingang S2 und einen symmetrischen Signalausgang c, c* vorgesehen hat, wobei der erste Eingang a, a* jeder Grundschaltung den Eingang eines symmetrischen Zeitgliedes ZG bildet, wobei der Ausgang dieses Zeitgliedes ZG mit dem symmetrischen ersten Eingang einer Verstärker-Addiererschaltung verbunden ist, wobei der symmetrische zweite Eingang b, b* jeder Grundschaltung GS1, GS2,... den zweiten Eingang dieser Verstärker-Addiererschaltung bildet, wobei der Referenzeingang S2 jeder Grundschaltung GS1, ... mit einem Referenzpotential beaufschlagbar ist und wobei der Steuereingang S1 jeder Grundschaltung GS1, GS2, ... zur Variation des Verhältnisses der zwischen dem ersten Eingang der Verstärker-Addiererschaltung und ihrem Ausgang wirksamen Verstärkung zu der zwischen dem zweiten Eingang der Verstärker-Addiererschaltung und ihrem Ausgang wirksamen Verstärkung mit einem Abstimmpotential beaufschlagbar ist, wobei der Phasenschieber-Oszillator aus mindestens zwei Grundschaltungen GS1, GS3 besteht, wobei der erste nichtinvertierende Eingang a sowie der erste invertierende Eingang a* jeder Grundschaltung derart mit den beiden Signalausgängen c, c* einer anderen Grundschaltung verbunden sind, daß jedem der besagten Eingangspaare a, a* genau ein Signalausgangspaar c,c* zugeordnet ist, wobei jeweils der erste nichtinvertierende Eingang a mit einem das nichtinvertierte Ausgangssignal führenden Signalausgang c und der erste invertierende Eingang a* mit dem entsprechenden, das nichtinvertierte Ausgangssignal führenden Signalausgang c* zusammengeschaltet ist und zur Erzeugung eines 180°-Phasensprungs nur der das nichtinvertierte Ausgangssignal führende Signalausgang c der ersten Grundschaltung GS1 an den ersten invertierenden Signaleingang a* der letzten Grundschaltung GS3 sowie an den zweiten invertierenden Signaleingang b* aller den Phasenschieber-Oszillator bildenden Grundschaltungen GS1, ... und der das invertierte Ausgangssignal führende Signalausgang c* der ersten Grundschaltung GS1 an den ersten nichtinvertierenden Eingang a der letzten Grundschaltung GS3 sowie an den zweiten nichtinvertierenden Eingang b aller den Phasenschieber-Oszillator bildenden Grundschaltungen GS1, GS2, ... geschaltet ist, wobei die ersten Steuereingänge S1 aller Grundschaltungen GS1, GS2,... zusammengeschaltet und mit einem Abstimmpotential Ua beaufschlagbar sind, wobei der Referenzeingang S2 jeder Grundschaltung GS1,GS2, ... mit einem Referenzpotential Ur1, Ur2, ... beaufschlagbar ist und wobei mindestens ein Signalausgang c,c* mindestens einer Grundschaltung GS1, GS2, ... als Signalausgang des Phasenschieber-Oszillators vorgesehen ist. Ein Vorteil eines erfindungsgemäßen Oszillators liegt in der vollständigen Integrierbarkeit der Schaltung bei großer Bandbreite.

In dem in FIG 1 gezeigten Ausführungsbeispiel sind drei Grundschaltungen GS1, GS2 und GS3 vorgesehen, deren Innenschaltungen identisch sein sollten, wobei jede Grundschaltung GS1, GS2, GS3 einen ersten nichtinvertierenden Eingang a, einen ersten invertierenden Eingang a*, einen zweiten nichtinvertierenden Eingang b, einen zweiten invertierenden Eingang b*, einen ersten Steuereingang S1, einen Referenzeingang S2, einen das nichtinvertierte Ausgangssignal führenden Signalausgang c und einen das nichtinvertierte Signal führenden Ausgang c* vorgesehen hat, wobei der erste nichtinvertierende Eingang a den ersten Eingang eines symmetrischen Zeitgliedes ZG und der erste invertierende Eingang a* den zweiten Eingang dieses Zeitgliedes ZG bildet, wobei ein erster Ausgang dieses Zeitgliedes ZG mit dem Basisanschluß eines ersten Transistors T1 und ein zweiter Ausgang dieses Zeitgliedes ZG mit dem Basisanschluß eines zweiten Transistors T2 verbunden ist, wobei der Emitteranschluß des ersten Transistors T1 gemeinsam mit dem Emitteranschluß des zweiten Transistors T2 an den Kollektor eines dritten Transistors T3 angeschlossen ist, wobei der Basisanschluß dieses dritten Transistors T3 den Steuereingang S1 der entsprechenden Grundschaltung GS1, ... bildet, wobei jeweils der zweite nichtinvertierende Eingang b jeder Grundschaltung GS1,GS2, ... mit dem Basisanschluß eines vierten Transistors T4 und der zweite invertierende Eingang b* mit dem Basisanschluß eines fünften Transistors T5 verbunden ist, wobei der Emitteranschluß des vierten Transistors T4 gemeinsam mit dem Emitteranschluß des fünften Transistors T5 an den Kollektor eines sechsten Transistors T6 angeschlossen ist, wobei der Basisanschluß dieses sechsten Transistors T6 den Referenzeingang S2 der jeweiligen Grundschaltung GS1,GS2, ... bildet, wobei die Kollektoranschlüsse des ersten und des vierten Transistors T1,T4 gemeinsam mit dem das invertierte Ausgangssignal führenden Signalausgang c* der entsprechenden Grundschaltung GS verbunden sind und über einen ersten Widerstand R1 an ein erstes Versorgungspotential V1 angeschlossen sind, wobei die Kollektoranschlüsse des zweiten und des fünften Transistors T2,T5 gemeinsam mit dem das nichtinvertierte Ausgangssignal führenden Signalausgang c der entsprechenden Grundschaltung GS1, ... verbunden sind und über einen zweiten Widerstand R2 ebenfalls an das erste Versorgungspotential V1 angeschlossen sind, wobei der Emitteranschluß des dritten Transistors T3 über eine erste Konstantstromquelle I1 an ein zweites Versorgungspotential V2 geschaltet ist, wobei der Emitteranschluß des fünften Transistors T5 über einen Koppelwiderstand Rk mit dem Emitteranschluß des sechsten Transistors T6 zusammengeschaltet und wobei der Emitteranschluß des sechsten Transistors T6 über eine zweite Konstantstromquelle I2 an das zweite Versorgungspotential (V2) geschaltet ist.

Als Zeitglied ZG ist in FIG 1 ein Differenzverstärker vorgesehen, der das Eingangssignal um seine Signallaufzeitkonstante verzögert. Hierbei bildet der Basisanschluß eines siebten Transistors T7 den einen Eingang und der Basisanschluß eines achten Transistors T8 den anderen Eingang des Zeitgliedes ZG. Die Emitteranschlüsse des siebten und des achten Transistors T7, T8 sind gemeinsam über eine dritte Konstantstromquelle I3 an ein Versorgungspotential, insbesondere an das zweite Versorgungspotential V2 geschaltet. Der Kollektor des siebten Transistors T7 ist über einen dritten Widerstand R3 und der Kollektor des achten Transistors T8 über einen vierten Widerstand R4 an ein anderes Versorgungspotential, insbesondere das erste Versorgungspotential V1 geschaltet und jeder dieser Kollektoren bildet einen Signalausgang des Zeitgliedes ZG.

Um die Verzögerungszeit zu vergrößern, können die Signalausgänge des Zeitgliedes ZG insbesondere durch parallel zur jeweiligen Last angeordnete Kapazitäten belastet werden und insbesondere kann ein Zeitglied ZG aus mehreren Zeitgliedern der beschriebenen Art, die in Serie geschaltet sind, aufgebaut werden. Außerdem kann das Zeitglied ZG aus jeder beliebigen Verzögerungsschaltung, beispielsweise einer RC-Kombination aufgebaut sein. In FIG 1 sind die Konstantstromquellen I1, I2, I3, die beliebig aufgebaut sein können, als Transistorschaltung dargestellt, wobei die Basis des jeweiligen Transistors mit einem konstanten Potential beaufschlagt ist, der Kollektor des jeweiligen Transistors den Stromeingang der jeweiligen Stromquelle bildet und der Emitter des jeweiligen Transistors über einen Widerstand mit dem Stromausgang der jeweiligen Stromquelle verbunden ist.

Infolge der Addition zweier phasenverschobener Signale entstehen unsaubere Signalflanken. Um ein Rechteck-Ausgangssignal mit scharfen Flanken zu erhalten, kann einer der Grundschaltungen (GS1, ...) eines Oszillators ein symmetrischer Komparator-Verstärker (A), beispielsweise ein im Schaltbetrieb arbeitender Differenzverstärker, nachgeschaltet werden.

Werden die invertierenden Eingänge (a*, b*) aller Grundschaltungen (GS1, GS2, ...) eines Oszillators auf ein gemeinsames Bezugspotential geschaltet, so erhält man einen Oszillator der erfindungsgemäßen Art für unsymmetrische Signale.

Ist die Abstimmspannung Ua in der in FIG 1 gezeigten Schaltung groß gegen alle Referenzspannungen Ur1, Ur2,...., so ist in jeder der Grundschaltung GS1, GS2,... der Gewichtsfaktor $X_1$ des am ersten Eingang a, a* eingespeisten Signales, das durch ein Zeitglied ZG verzögert wird, groß gegen den Gewichtsfaktor $X_2$ des am zweiten Eingang b, b* eingespeisten Signales. Weil alle Zeitglieder wirksam sind, ist die Ring-Signallaufzeit $T_n$ im Oszillator in diesem Falle maximal, was zu einer minimalen VCO-Frequenz führt. Ist die Abstimmspannung Ua klein gegen alle Referenzspannungen Ur1, Ur2,..., so daß der aus den Gewichtsfaktoren $X_1$ und $X_2$ gebildete Koeffizient $X = X_1/X_2$ minimal ist, so ist die Ring-Signallaufzeit $T_1$ im Oszillator minimal und die VCO-Frequenz maximal.

Die Änderung des Gewichtsfaktor-Koeffizienten X in Abhängigkeit von der Abstimmspannung Ua kann durch den Koppelwiderstand Rk beeinflußt werden. Je kleiner der Koppelwiderstand Rk, desto mehr verändert sich der Gewichtsfaktor-Koeffizient X bei gleicher Änderung der Abstimmspannung.

Bei einer minimalen Ring-Signallaufzeit $T_1$ und einer maximalen Ring-Signallaufzeit $T_n = nT_1$, wobei n eine beliebige reelle Zahl größers als 1 sein kann, gilt für den Kehrwert der Oszillatorfrequenz $1/f_{VCO} = 2 (T_1 + X (T_n - T_1))$ oder $1/_{VCO} = 2 T_1 (1 + (n - 1) X)$. Zwischen der Änderung der Frequenz $f_{VCO}$ und der Änderung des Gewichtsfaktor-Koeffizienten X besteht also ein hyperbolischer Zusammenhang.

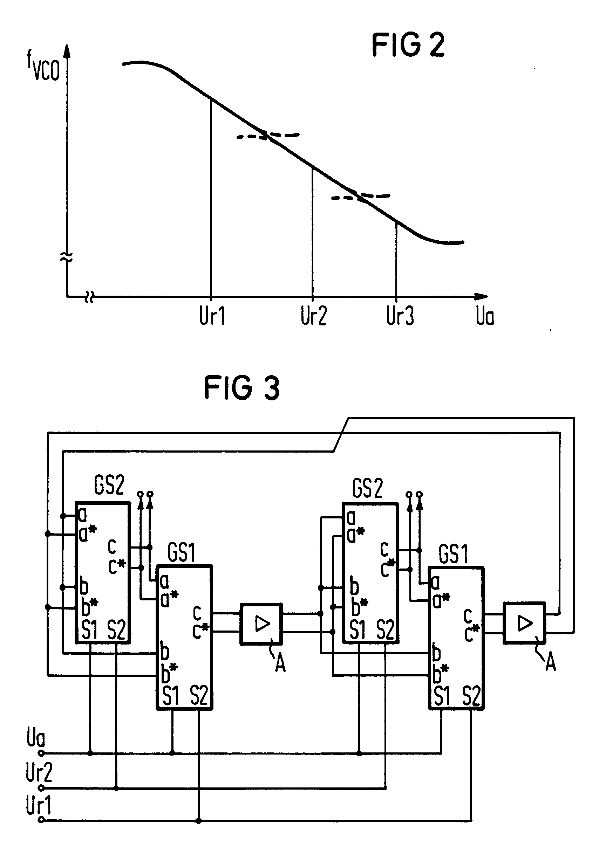

FIG 2 zeigt den Zusammenhang zwischen dem Abstimmpotential Ua und der Ausgangsfrequenz $f_{VCO}$, wie er mit einer Schaltung nach FIG 1 durch die Wahl spezieller Werte der Referenzpotentiale Ur1, Ur2 und Ur3 und spezieller Widerstandswerte für die Koppelwiderstände Rk der Grundschaltungen GS1, GS2 und GS3 erreicht werden kann. Hierbei ist die Steigung der Frequenz-Abstimmpotential-Kennlinie über einen breiten Frequenzbereich konstant. Die unterbrochenen Linien geben jeweils den Kennlinienverlauf an, der sich einstellen würde, wenn der Oszillator nur aus einer der Grundschaltungen GS1, GS2 bzw. GS3 bestehen würde. Hierbei ist zu erkennen, daß bei höheren Frequenzen zum Erzielen des gleichen Frequenzunterschiedes ein größerer Spannungsunterschied erforderlich ist, als bei niedrigeren Frequenzen, was auf den oben erwähnten hyperbolischen Zusammenhang zwischen der Frequenzänderung des Oszillators und der Änderung des Gewichtsfaktor-Koeffizienten X zurückzuführen ist. Die entsprechende Angleichung der Kennlinie wird bei ansonsten identischen Grundschaltungen GS1, GS2 und GS3 dadurch erreicht, daß der Koppelwiderstand Rk in der Grundschaltung GS1 größer ist als in der Grundschaltung GS2 und daß der Koppelwiderstand Rk in der Grundschaltung GS3 wiederum kleiner ist als in der Grundschaltung GS2. Die Referenzpotentiale Ur1, Ur2,..., die zur Beaufschlagung des jeweiligen Referenzeinganges S2 der einzelnen Grundschaltungen GS1, GS2, ... vorgesehen sind, werden sinnvollerweise so gewählt, daß die maximale Steuerspannung (Ua - Ur1)max des linearen Bereiches der Frequenz-Abstimmspannungskennlinie der ersten Grundschaltung GS1 nahezu gleich der minimalen Steuerspannung (Ua - Ur2)min des linearen Bereiches der Frequenz-Abstimmspannungs-Kennlinie der zweiten Grundschaltung GS2 ist und daß sich die Kennlinien evtl. weiterer Grundschaltungen GS3, ... in gleicher Weise zu einer linearen Frequenz-Abstimmpotential-Kennlinie des Gesamtoszillators ergänzen.

In FIG 3 wird eine spezielle Ausführungsform eines erfindungsgemäßen Oszillators gezeigt, mit der der Frequenzbereich des Oszillators bei gegebenen Grundschaltungen, deren Signallaufzeiten technologisch bedingt und nicht in weiten Bereichen variierbar sind, zu niedrigen Frequenzen hin verschoben werden kann. Das der Funktionsweise der in FIG 3 gezeigten Schaltung zugrunde gelegte Prinzip, durch Hintereinanderschalten mehrerer Oszillatorstufen zu einem mehrstufigen Phasenschieberoszillator die Oszillatorfrequenz herabzusetzen, ist aus dem oben erwähnten Buch von J. L. Stewart "Theorie und Entwurf elektronischer Netzwerke", Berliner Union, Stuttgart, 1958 auf den Seiten 379 und 380 beschrieben und am Beispiel eines dreistufigen Phasenschieberoszillators in Röhrentechnik dargelegt. Ein besonderer Vorteil solcher Schaltungen bei Verwendung identischer Oszillatorstufen liegt darin, daß am Ausgang jeder Oszillatorstufe ein Ausgangssignal gleicher Frequenz abgegriffen werden kann, wobei diese Ausgangssignale in fester Phasenbeziehung zueinander stehen. Ist beispielsweise n die Anzahl der in Reihe geschalteten identischen Oszillatorstufen, so ist das Ausgangssignal einer Oszillatorstufe zu dem der vorangehenden und dem der nachfolgenden Stufe in der Phase um 180°/n verschoben. Zu den invertierten Ausgangssignalen benachbarte Oszillatorstufen ist das Ausgangssignal dann in der Phase um 180° + 180°/n bzw. 180° -180°/n verschoben. Als besonderer Effekt einer Schaltung nach FIG 3 ist zu bemerken, daß durch identische Ansteuerung der Steuer- und Referenzeingänge der einzelnen Oszillatorstufen, die beispielsweise in den Ansprüchen 1, 2, 3 oder 4 beschrieben sind, ein Herabsetzen der Oszillatorfrequenz das Verhältnis zwischen der maximal und der minimal durch die Abstimmspannung Ua einstellbaren Oszillatorfrequenz nicht verschlechtert. FIG 3 zeigt insbesondere einen Phasenschieber-Oszillator, bestehend aus Phasenschieber-Oszillatoren nach einem der Ansprüche 1, 2, 3 oder 4, wobei mindestens zwei Phasenschieber-Oszillatoren nach einem der Ansprüche 1, 2, 3 oder 4 derart einen Ringoszillator bilden, daß der Signalausgang c, c* der ersten Grundschaltung GS1 eines Phasenschieber-Oszillators nach einem der Ansprüche 1, 2, 3 oder 4 mit dem symmetrischen ersten Eingang a, a* eines anderen Phasenschieber-Oszillators nach einem der Ansprüche 1, 2, 3 oder 4 und außerdem mit dem symmetrischen zweiten Signaleingang b, b* aller Grundschaltungen GS1, GS2, ... dieses anderen Phasenschieber-Oszillators zusammengeschaltet ist, wobei nur einmal zur Erzeugung eines 180°-Phasensprunges der das invertierte Ausgangssignal führende Signalausgang c* an die nichtinvertierenden Eingänge a, b und der das nichtinvertierte Ausgangssignal führende Signalausgang c an die invertierenden Eingängen a*, b* angeschlossen ist und wobei die Signalausgänge der einzelnen Grundschaltungen GS1, GS2,..jeweils zur Bereitstellung von gegeneinander phasenverschobenen Ausgangssignalen des Phasenschieber-Oszillators vorgesehen sind.

## Patentansprüche

1. Phasenschieber-Oszillator mit spannungssteuerbarer Ausgangsfrequenz, bestehend aus Grundschaltungen (GS1, GS2, GS3...) mit jeweils einem symmetrischen ersten Eingang (a, a*), einem symmetrischen zweiten Eingang (b, b*), einem Steuereingang (S1), einem Referenzeingang (S2) und einem symmetrischen Signalausgang (c, c*), wobei der erste Eingang (a, a*) jeder Grundschaltung den Eingang eines symmetrischen Zeitgliedes (ZG) bildet, wobei der Ausgang dieses Zeitgliedes (ZG) mit dem symmetrischen ersten Eingang einer Verstärker-Addiererschaltung verbunden ist, wobei der symmetrische zweite Eingang (b, b*) jeder Grundschaltung (GS1, GS2,...) den zweiten Eingang dieser Verstärker-Addiererschaltung bildet, wobei der Referenzeingang (S2) jeder Grundschaltung (GS1, ...) mit einem Referenzpotential beaufschlagbar ist und wobei der Steuereingang (S1) jeder Grundschaltung (GS1, GS2, ...) zur Variation des Verhältnisses der zwischen dem ersten Eingang der Verstärker-Addiererschaltung und ihrem Ausgang wirksamen Verstärkung zu der zwischen dem zweiten Eingang der Verstärker-Addiererschaltung und ihrem Ausgang wirksamen Verstärkung mit einem Abstimmpotential beaufschlagbar ist,

**dadurch gekennzeichnet**,

daß der Phasenschieber-Oszillator aus mindestens zwei Grundschaltungen (GS1,GS3) besteht, daß der erste nichtinvertierende Eingang (a) sowie der erste invertierende Eingang (a*) jeder Grundschaltung derart mit den beiden Signalausgängen (c,c*) einer anderen Grundschaltung verbunden sind, daß jedem der besagten Eingangspaare (a,a*) genau ein Signalausgangspaar (c,c*) zugeordnet ist, wobei jeweils der erste nichtinvertierende Eingang (a) mit einem das nichtinvertierte Ausgangssignal führenden Signalausgang (c) und der erste invertierende Eingang (a*) mit dem entsprechenden, das invertierte Ausgangssignal führenden Signalausgang (c*) zusammengeschaltet ist und nur der das nichtinvertierte Ausgangssignal führende Signalausgang (c) der ersten Grundschaltung (GS1) an den ersten invertierenden Signaleingang (a*) der letzten Grundschaltung (GS3) sowie an den zweiten invertierenden Signaleingang (b*) aller den Phasenschieber-Oszillator bildenden Grundschaltungen (GS1, ...) und der das invertierte Ausgangssignal führende Signalausgang (c*) der ersten Grundschaltung (GS1) an den ersten nichtinvertierenden Eingang (a) der letzten Grundschaltung (GS3) sowie an den zweiten nichtinvertierenden Eingang (b) aller den Phasenschieber-Oszillator bildenden Grundschaltungen (GS1, GS2, ...) geschaltet ist, daß die ersten Steuereingänge (S1) aller Grundschaltungen (GS1, GS2, ...) zusammengeschaltet und mit einem Abstimmpotential (Ua) beaufschlagbar sind, daß der Referenzeingang (S2) jeder Grundschaltung (GS1, GS2, ...) mit

6

einem Referenzpotential (Ur1, Ur2, ...) beaufschlagbar ist und daß mindestens ein Signalausgang (c, c*) mindestens einer Grundschaltung (GS1, GS2, ...) als Signalausgang des Phasenschieber-Oszillators vorgesehen ist.

**2.** Phasenschieber-Oszillator nach Patentanspruch 1,
**dadurch gekennzeichnet**,
daß jede Grundschaltung (GS1, GS2) einen ersten nichtinvertierenden Eingang (a), einen ersten invertierenden Eingang (a*), einen zweiten nichtinvertierenden Eingang (b), einen zweiten invertierenden Eingang (b*), einen Steuereingang (S1), einen Referenzeingang (S2), einen das nichtinvertierte Ausgangssignal führenden Signalausgang (c) und einen das invertierte Ausgangssignal führenden Signalausgang (c*) vorgesehen hat, daß eine erste Ausgangsklemme dieses Zeitgliedes (ZG) mit dem Basisanschluß eines ersten Transistors (T1) und ein zweiter Ausgang dieses Zeitgliedes (ZG) mit dem Basisanschluß eines zweiten Transistors verbunden ist, daß der Emitteranschluß des ersten Transistors (T1) gemeinsam mit dem Emitteranschluß des zweiten Transistors (T2) an den Kollektor eines dritten Transistors (T3) angeschlossen ist, daß der Basisanschluß dieses dritten Transistors (T3) den Steuereingang (S1) der entsprechenden Grundschaltung (GS1, ...) bildet, wobei jeweils der zweite nichtinvertierende Eingang (b) jeder Grundschaltung (GS1, GS2, ...) mit dem Basisanschluß eines vierten Transistors (T4) und der zweite invertierende Eingang (b*) mit dem Basisanschluß eines fünften Transistors (T5) verbunden ist, daß der Emitteranschluß des vierten Transistors (T4) gemeinsam mit dem Emitteranschluß des fünften Transistors (T5) an den Kollektor eines sechsten Transistors (T6) angeschlossen ist, daß der Basisanschluß dieses sechsten Transistors (T6) den Referenzeingang (S2) der jeweiligen Grundschaltung (GS1, GS2, ...) bildet, daß die Kollektoranschlüsse des ersten und des vierten Transistors (T1, T4) gemeinsam mit dem das invertierte Ausgangssignal führenden Signalausgang (c*) der entsprechenden Grundschaltung (GS1,...) verbunden sind und über einen ersten Widerstand (R1) an ein erstes Versorgungspotential (V1) angeschlossen sind, daß die Kollektoranschlüsse des zweiten und des fünften Transistors (T2, T5) gemeinsam mit dem das nichtinvertierte Ausgangssignal führenden Signalausgang (c) der entsprechenden Grundschaltung (GS1, ...) verbunden sind und über einen zweiten Widerstand (R2) ebenfalls an das erste Versorgungspotential (V1) angeschlossen sind, daß der Emitteranschluß des dritten Transistors (T3) über eine erste Konstantstromquelle (I1) an ein zweites Versorgungspotential (V2) geschaltet ist, daß der Emitteranschluß des fünften Transistors (T5) über einen Koppelwiderstand (Rk) mit dem Emitteranschluß des sechsten Transistors (T6) zusammengeschaltet ist und daß der Emitteranschluß des sechsten Transistors (T6) über eine zweite Konstantstromquelle (I2) an das zweite Versorgungspotential (V2) geschaltet ist.

**3.** Phasenschieber-Oszillator nach Anspruch 1 oder 2,
**dadurch gekennzeichnet**,
daß als Zeitglied (ZG) eine Differenzverstärkerschaltung, bestehend aus einem siebsten und achten Transistor (T7, T8), vorgesehen ist, daß hierbei der Basisanschluß des Transistors (T7) und der Basisanschluß des achten Transistors (T8) je eine Eingangsklemme des symmetrischen Einganges des Zeitgliedes (ZG) bildet, daß die Emitteranschlüsse des siebten und des achten Transistors (T7, T8) miteinander verbunden sind und gemeinsam über eine dritte Konstantstromquelle (I3) an ein Versorgungspotential geschaltet sind, daß der Kollektoranschluß des siebten Transistors (T7) über einen dritten Widerstand (R3) und der Kollektoranschluß des achten Transistors (T8) über einen vierten Widerstand (R4) an ein gemeinsames, anderes Versorgungspotential geschaltet sind und daß der Kollektoranschluß des siebten Transistors (T7) und der Kollektoranschluß des achten Transistors (T8) je eine Ausgangsklemme des symmetrischen Ausganges des Zeitgliedes (ZG) bilden.

**4.** Phasenschieber-Oszillator nach einem der Ansprüche 1 bis 3,
**dadurch gekennzeichnet**,
daß dem Signalausgang der ersten Grundschaltung (GS1) ein symmetrischer Verstärker nachgeschaltet ist.

**5.** Phasenschieber-Oszillator, bestehend aus Phasenschieber-Oszillatoren nach einem der Ansprüche 1, 2, 3 oder 4,
**dadurch gekennzeichnet**,
daß mindestens zwei Phasenschieber-Oszillatoren nach einem der Ansprüche 1, 2, 3 oder 4 derart einen Ringoszillator bilden, daß der Signalausgang (c, c*) der ersten Grundschaltung (GS1) eines Phasenschieber-Oszillators nach einem der Ansprüche 1, 2, 3 oder 4 mit dem symmetrischen ersten Eingang (a, a*) eines anderen Phasenschieber-Oszillators nach einem der Ansprüche 1, 2, 3 oder 4 und außerdem mit dem symmetrischen zweiten Signaleingang (b, b*) aller Grundschaltungen (GS1, GS2, ...) dieses anderen Phasenschieber-Oszillators zusammengeschaltet ist, wobei nur einmal der das invertierte Ausgangssignal führende Signalausgang (c*) an die nichtinvertierenden Eingänge (a, b) und der das nichtinvertierte Ausgangssignal führende Signalausgang (c) an die invertierenden Eingängen (a*, b*) angeschlossen ist.

6. Phasenschieber-Oszillator nach einem der Ansprüche 1 bis 5,
   **dadurch gekennzeichnet**,
   daß die invertierenden Eingänge (a*, b*) aller Grundschaltungen (GS1, GS2, ...) an ein gemeinsames Bezugspotential geschaltet sind.

7. Phasenschieber-Oszillator nach Anspruch 5,
   **dadurch gekennzeichnet**,
   daß die Signalausgänge der einzelnen Grundschaltungen (GS1, GS2, ...) jeweils zur Bereitstellung von gegeneinander phasenverschobenen Ausgangssignalen des Phasenschieber-Oszillators vorgesehen sind.

**Claims**

1. Phase shifter oscillator with voltage-controllable output frequency, comprising fundamental circuits (GS1, GS2, GS3...) having in each case a symmetrical first input (a, a*), a symmetrical second input (b, b*), a control input (S1), a reference input (S2) and a symmetrical signal output (c, c*), in which the first input (a, a*) of each fundamental circuit forms the input of a symmetrical timing element (ZG), in which the output of said timing element (ZG) is connected to the symmetrical first input of an amplifier adding circuit, in which the symmetrical second input (b, b*) of each fundamental circuit (GS1, GS2, ...) forms the second input of said amplifier adding circuit, in which a reference potential can be applied to the reference input (S2) of each fundamental circuit (GS1, ...), and in which a tuning potential can be applied to the control input (S1) of each fundamental circuit (GS1, GS2, ...) for varying the ratio of the amplification effective between the first input of the amplifier adding circuit and its output to the amplification effective between the second input of the amplifier adding circuit and its output, characterised in that the phase shifter oscillator comprises at least two fundamental circuits (GS1, GS3), in that the first non-inverting input (a) and also the first inverting input (a*) of each fundamental circuit are connected to the two signal outputs (c, c*) of another fundamental circuit in such a way that exactly one signal output pair (c, c*) is assigned to each of the aforesaid input pairs (a, a*), in each case the first non-inverting input (a) being interconnected with a signal output (c) carrying the non-inverted output signal and the first inverting input (a*) being interconnected with the corresponding signal output (c*) carrying the inverted output signal, and only the signal output (c), carrying the non-inverted output signal, of the first fundamental circuit (GS1) being connected to the first inverting signal input (a*) of the last fundamental circuit (GS3) and also to the second inverting signal input (b*) of all the fundamental circuits (GS1, ...) forming the phase shifter oscillator, and the signal output (c*), carrying the inverted output signal, of the first fundamental circuit (GS1) being connected to the first non-inverting input (a) of the last fundamental circuit (GS3) and also to the second non-inverting input (b) of all the fundamental circuits (GS1, GS2, ...) forming the phase shifter oscillator, in that the first control inputs (S1) of all the fundamental circuits (GS1, GS2, ...) are interconnected and can receive a tuning potential (Ua), in that a reference potential (Ur1, Ur2, ...) can be applied to the reference input (S2) of each fundamental circuit (GS1, GS2, ...), and in that at least one signal output (c, c*) of at least one fundamental circuit (GS1, GS2, ...) is provided as signal output of the phase shifter oscillator.

2. Phase shifter oscillator according to Claim 1, characterised in that there is provided in each fundamental circuit (GS1, GS2) a first non-inverting input (a), a first inverting input (a*), a second non-inverting input (b), a second inverting input (b*), a control input (S1), a reference input (S2), a signal output (c) carrying the non-inverted output signal and a signal output (c*) carrying the inverted output signal, in that a first output terminal of said timing element (ZG) is connected to the base terminal of a first transistor (T1) and a second output of said timing element (ZG) is connected to the base terminal of a second transistor, in that the emitter terminal of the first transistor (T1) is connected together with the emitter terminal of the second transistor (T2) to the collector of a third transistor (T3), in that the base terminal of said third transistor (T3) forms the control input (S1) of the corresponding fundamental circuit (GS1, ...), the second non-inverting input (b) of each fundamental circuit (GS1, GS2, ...) being connected in each case to the base terminal of a fourth transistor (T4) and the second inverting input (b*) being connected to the base terminal of a fifth transistor (T5), in that the emitter terminal of the fourth transistor (T4) is connected together with the emitter terminal of the fifth transistor (T5) to the collector of a sixth transistor (T6), in that the base terminal of said sixth transistor (T6) forms the reference input (S2) of the respective fundamental circuit (GS1, GS2, ...), in that the collector terminals of the first and of the fourth transistor (T1, T4) are connected together to the signal output (c*), carrying the inverted output signal, of the corresponding fundamental circuit (GS1, ...) and are connected via a first resistor (R1) to a first supply potential (V1), in that the collector terminals of the second and of the fifth transistor (T2, T5) are connected together to the signal output (c), carrying the non-inverted output signal, of the corresponding fundamental circuit (GS1, ...) and are likewise connected via a second resistor (R2) to the first supply potential (V1), in that the emitter terminal of the third transistor (T3) is connected via a first constant current source (I1) to a second supply potential (V2), in that the emitter terminal of the fifth transistor (T5) is interconnected via a coupling resistor (Rk) with the emitter terminal of the sixth transistor (T6), and in that the emitter terminal of the sixth transistor (T6) is connected via a second constant current source (I2) to the second supply potential (V2).

3. Phase shifter oscillator according to Claim 1 or 2, characterised in that a differential amplifier circuit comprising a seventh and eighth transistor (T7, T8) is provided as timing element (ZG), in that in this arrangement the base terminal of the transistor (T7) and the base terminal of the eighth transistor (T8) each form one input terminal of the symmetrical input of the timing element (ZG), in that the emitter terminals of the seventh and of the eighth transistor (T7, T8) are connected to one another and are connected together via a third constant current source (I3) to a supply potential, in that the collector terminal of the seventh transistor (T7) is connected via a third resistor (R3) and the collector terminal of the eighth transistor (T8) is connected via a fourth transistor (R4) to a common, other supply potential, and in that the collector terminal of the seventh transistor (T7) and the collector terminal of the eighth transistor (T8) each form one output terminal of the symmetrical output of the timing element (ZG).

4. Phase shifter oscillator according to one of Claims 1 to 3, characterised in that a symmetrical amplifier is connected downstream of the signal output of the first fundamental circuit (GS1).

5. Phase shifter oscillator, comprising phase shifter oscillators according to one of Claims 1, 2, 3 or 4, characterised in that at least two phase shifter oscillators according to one of Claims 1, 2, 3 or 4 form a ring oscillator in such a way that the signal output (c, c*) of the first fundamental circuit (GS1) of a phase shifter oscillator according to one of Claims 1, 2, 3 or 4 is interconnected with the symmetrical first input (a, a*) of another phase shifter oscillator according to one of Claims 1, 2, 3 or 4 and in addition with the symmetrical second signal input (b, b*) of all the fundamental circuits (GS1, GS2, ...) of said other phase shifter oscillator, the signal output (c*) carrying the inverted output signal being connected only once to the non-inverting inputs (a, b) and the signal output (c) carrying the non-inverted output signal being connected only once to the inverting inputs (a*, b*).

6. Phase shifter oscillator according to one of Claims 1 to 5, characterised in that the inverting inputs (a*, b*) of all the fundamental circuits (GS1, GS2, ...) are connected to a common reference potential.

7. Phase shifter oscillator according to Claim 5, characterised in that the signal outputs of the individual fundamental circuits (GS1, GS2, ...) are provided in each case for the provision of mutually phase-shifted output signals of the phase shifter oscillator.

**Revendications**

1. Oscillateur-déphaseur possédant une fréquence de sortie pouvant être commandée par la tension, constitué par des circuits de base (GS1,GS2,GS3...) comportant respectivement une première entrée symétrique (a,a*), une seconde entrée symétrique (b,b*), une entrée de commande (S1), une entrée de référence (S2) et une sortie symétrique de signaux (c,c*), et dans lequel la première entrée (a,a*) de chaque circuit de base constitue l'entrée d'un circuit de temporisation symétrique (ZG), la sortie de ce circuit de temporisation (ZG) étant raccordée à la première entrée symétrique d'un circuit additionneur-amplificateur, la seconde entrée symétrique (b,b*) de chaque circuit de base (GS1,GS2,...) constituant la seconde entrée de ce circuit additionneur-amplificateur, l'entrée de référence (S2) de chaque circuit de base (GS1,...) pouvant être chargée par un potentiel de référence, et l'entrée de commande (S1) de chaque circuit de base (GS1,GS2,...) pouvant être chargée par un potentiel de réglage d'accord pour modifier le rapport de l'amplification agissant entre la première entrée du circuit additionneur-amplificateur et de sa sortie, par rapport à l'amplification active entre la seconde entrée du circuit additionneur-amplificateur et sa sortie,

caractérisé par le fait

que l'oscillateur-déphaseur est constitué par au moins deux circuits de base (GS1,GS3), que la première entrée non inverseuse (a) ainsi que la première entrée inverseuse (a*) de chaque circuit de base sont réunies aux sorties de signaux (c,c*) d'un autre circuit de base, qu'à chacun desdits couples d'entrées (a,a*) est associé de façon précise un couple de sorties de signaux (c,c*), respectivement la première entrée non inverseuse (a) pouvant être interconnectée à une sortie de signal (c), qui transmet le signal de sortie non inversé, et la première entrée inverseuse (a*) étant interconnectée à la sortie de signal correspondante (c*) qui transmet le signal de sortie inversé, et seule la sortie de signal (c), qui transmet le signal de sortie non inversé, du premier circuit de base (GS1) étant raccordée à la première entrée inverseuse de signal (a*) du dernier circuit de base (GS3) ainsi qu'à la seconde entrée inverseuse de signal (b*) de tous les circuits de base (GS1,...) constituant l'oscillateur-déphaseur, et la sortie de signal (c*), qui transmet le signal de sortie inversé, du premier circuit de base (GS1) étant raccordée à la première entrée non inverseuse (a) du dernier circuit de base (GS3) ainsi qu'à la seconde entrée non inverseuse (b) de tous les circuits de base (GS1,GS2...) constituant l'oscillateur-déphaseur, que les premières entrées de conmande (S1) de tous les circuits de base (GS1,GS2,...) sont interconnectées et peuvent être chargées par un potentiel de réglage d'accord (Ua), que l'entrée de référence (S2) de chaque circuit de base (GS1,GS2,...) peut être chargée par un potentiel de référence (Ur1,Ur2,...) et qu'au moins une sortie de signal (c,c*) d'au moins un circuit de base (GS1,GS2,...) est prévue en tant que sortie de signal de l'oscillateur-déphaseur.

2. Oscillateur-déphaseur suivant la revendication 1, caractérisé par le fait

que chaque circuit de base (GS1,GS2) possède une première entrée non inverseuse (a), une première entrée inverseuse (a*), une seconde entrée non inverseuse (b), une seconde entrée inverseuse (b*), une entrée de commande (S1), une entrée de référence (S2), une sortie de signal (c), qui transmet le signal de sortie non inversé, et une entrée de signal (c*) qui transmet le signal de sortie inversé, qu'une première borne de sortie de ce circuit de temporisation (ZG) est racordée à la borne de base d'un premier transistor (T1) et qu'une seconde sortie de ce circuit de temporisation (ZG) est raccordée à la borne de base d'un second transistor, que la borne d'émetteur du premier transistor (T1) est raccordée, conjointement avec la borne d'émetteur du second transistor (T2), au collecteur d'un troisième transistor (T3), que la borne de base de ce troisième transistor (S3) forme l'entrée de commande (S1) du circuit de base correspondant (GS1,...), que respectivement la seconde entrée non inverseuse (b) de chaque circuit de base (GS1,GS2,...) est raccordée à la borne de base d'un quatrième transistor (T4) et que la seconde entrée inverseuse (b*) est raccordée à la borne de base d'un cinquième transistor (T5), que la borne d'émetteur du quatrième transistor (T4) est raccordée, conjointement avec la borne d'émetteur du cinquième transistor (T5), au collecteur d'un sixième transistor (T6), que la borne de base de ce sixième transistor (T6) forme l'entrée de référence (S2) du circuit de base respectif (GS1,GS2,...), que les bornes de collecteur des premier et quatrième transistors (T1,T4) sont raccordées en commun à la sortie de signal (c*), qui transmet le signal de sortie inversé, du circuit de base correspondant (GS1,...) et sont raccordés, par l'intermédiaire d'une première résistance (R1), à un premier potentiel d'alimentation (V1), que les bornes de collecteur des second et cinquième transistors (T2,T5) sont raccordées en commun à la sortie de signal (c), qui transmet le signal de sortie non inversé, au circuit de base correspondant (GS1,...) et, par l'intermédiaire d'une seconde résistance (R1), également au premier potentiel d'alimentation (G1), que la borne d'émetteur du troisième transistor (T3) est raccordée, par l'intermédiaire d'une première source de courant constant (I1), à un second potentiel d'alimentation (V2), que la borne d'émetteur du cinquième transistor (T5) est raccordée par l'intermédiaire d'une résistance de couplage (Rk) à la borne d'émetteur du sixième transistor (T6) et que la borne d'émetteur du sixième transistor (T6) est raccordée par l'intermédiaire d'une seconde source de courant constant (I2) au second potentiel d'alimentation (V2).

3. Oscillateur-déphaseur suivant la revendication 1 ou 2, caractérisé par le fait

qu'il est prévu comme circuit de temporisation (ZG), un circuit amplificateur différentiel constitué par des septième et huitième transistors (T7,T8), que la borne de base du transistor (T7) et la borne de base du huitième transistor (T8) forment respectivement une borne d'entrée de l'entrée symétrique du circuit de temporisation (ZG), que les bornes d'émetteur des septième et huitième transistors (T7,T8) sont raccordées entre elles et en commun par l'intermédiaire d'une troisième source de courant constant (I3) à un potentiel d'alimentation, que la borne du collecteur du septième transistor (T7) est raccordée par l'intermédiaire d'une troisième résistance (R3) et de la borne de collecteur du huitième transistor (T8) est raccordée, par l'intermédiaire d'une quatrième résistance (R4), à un autre potentiel d'alimentation commun et que la borne de collecteur du septième transistor (T7) et la borne de collecteur du huitième transistor (T6) forment respectivement une borne de sortie de la sortie symétrique du circuit de temporisation (ZG).

4. Oscillateur-déphaseur suivant l'une des revendications 1 à 3, caractérisé par le fait qu'un amplificateur symétrique est branché en aval de la sortie des signaux du premier circuit de base (GS1).

5. Oscillateur-déphaseur, constitué par des oscillateurs-déphaseurs suivant l'une des revendications 1, 2, 3 ou 4, caractérisé par le fait qu'au moins deux oscillateurs-déphaseurs suivant l'une des revendications 1, 2, 3 ou 4 forment de telle manière un oscillateur en anneau, que la sortie de signal (c,c*) du premier circuit de base (GS1) d'un oscillateur-déphaseur suivant l'une des revendications 1,2,3 ou 4 est raccordé à la première entrée symétrique (a,a*) d'un autre oscillateur-déphaseur suivant l'une des revendications 1, 2, 3 ou 4 et en outre, à la seconde entrée symétrique de signal (b,b*) de tous les circuits de base (GS1,GS2,...) de cet autre oscillateur-déphaseur, seule la sortie de signal (c*), qui transmet le signal de sortie inversé, étant raccordée aux entrées non inverseuses (a,b), tandis que la sortie de signal (c), qui transmet le signal de sortie non inversé, est raccordée aux entrées inverseuses (a*,b*).

6. Oscillateur-déphaseur suivant l'une des revendications 1 à 5, caractérisé par le fait que les entrées inverseuses (a*,b*) de tous les circuits de base (GS1,GS2,...) sont raccordées à un potentiel de référence commun.

7. Oscillateur-déphaseur suivant la revendication 5, caractérisé par le fait que les signaux de sortie des différents circuits (GS1,GS2,...) sont prévus respectivement pour la préparation de signaux de sortie réciproquement déphasés de l'oscillateur-déphaseur.

EP 0 316 607 B1

# FIG 1

# FIG 2

# FIG 3